Europäisches Patentamt

European Patent Office

Office européen des brevets

(11) Veröffentlichungsnummer: **0 430 243 A2**

## EUROPÄISCHE PATENTANMELDUNG

(21) Anmeldenummer: 90122857.7

(22) Anmeldetag: 29.11.90

(51) Int. Cl.5: **H01L 23/538**

(30) Priorität: 01.12.89 DE 3939794

(43) Veröffentlichungstag der Anmeldung:
05.06.91 Patentblatt 91/23

(84) Benannte Vertragsstaaten:
FR GB IT Patentblatt

(71) Anmelder: SEMIKRON ELEKTRONIK GMBH
Sigmundstrasse 200 Postfach 82 02 51
W-8500 Nürnberg 82(DE)

(72) Erfinder: Augustin, Karl-Heinz
Oberführberger Strasse 16
W-8510 Fürth(DE)
Erfinder: Schötz, Walter
Philippstrasse 42
W Nürnberg 80(DE)

(54) Trägerplatte für Halbleiterbaueinheiten.

(57) 1. Trägerplatte für Halbleiter-Baueinheiten.

2.1 Bekannte Trägerplatten aus wärmeleitender Keramik zur Verwendung als isolierende Zwischenscheibe weisen infolge fertigungsbedingter, unerwünschter Lageveränderung von Keramik und als Metallisierungen vorgesehenen Kontaktplatinen unzulässige Toleranzen von Endmaßen und von Kontaktflächenbereichen auf, welche eine unwirtschaftliche Weiterverarbeitung zur Folge haben.

Die Trägerplatte nach der Erfindung ermöglicht beliebige Strukturierung der Metallisierung, einwandfreie Justierung zur Weiterbearbeitung und die Erfüllung gewünschter Maßvorgaben.

2.2 Bei der neuen Trägerplatte ist wenigstens eine Metallisierung aus einer an allen Kanten über die Keramik vorstehenden Metallplatte und auf eine der Keramik angepaßte Flächenausdehnung verringert ausgebildet und weist über die Keramik hinausragende Fortsätze auf. Diese sind gebogen oder vieleckförmig ausgebildet sowie im Verlauf der Keramikkanten oder an den Keramikecken angebracht.

2.3 Die Trägerplatte betrifft alle Aufbauten mit potentialfreier Befestigung von Bauteilen.

EP 0 430 243 A2

**DIE ERFINDUNG BETRIFFT EINE TRÄGERPLATTE FÜR HALBLEITER-BAUEINHEITEN NACH DEM OBERBE-GRIFF DES ANSPRUCHS 1.**

Zum potentialfreien Aufbau einer Halbleiter-Baueinheit aus Halbleitertablette(n) mit einem oder mehr Funktionsbereichen und aus Anschlußbauteilen ist zwischen Tablette und einer metallischen Grundplatte eine nachstehend als Trägerplatte bezeichnete, elektrisch isolierende Zwischenscheibe eingefügt. Diese besteht zur Erzielung eines gewünschten thermischen Betriebsverhaltens aus einer wärmeleitenden Keramik. Infolge der unterschiedlichen thermischen Ausdehnungskoeffizienten der aneinandergrenzenden Materialien Metall, Keramik, Halbleiter, wobei die Keramik zu ihrer beidseitigen festen Verbindung mit Metallisierungen versehen ist, kommt es insbesondere bei Lötprozessen zur Herstellung eines solchen Aufbaus zu unerwünschter Verwölbung der Teilefolge aus Grundplatte und Trägerplatte und damit zu einer unzulässigen mechanischen Beanspruchung der darauf befestigten Halbleitertablette. Die Wölbung ist umso größer, je dünner die Grundplatte und/oder je größer die Flächenausdehnung der Teilefolge ist.

Über lange Zeit wurden Keramiken mit beidseitiger dünner Metallisierung z.B. aus lötfähiger Metallpaste verwendet. Die benutzten Metallisierungen waren jedoch für eine gleichmäßige Verteilung der in den Halbleitertabletten erzeugten Verlustwärme sowie für die auftretenden Stromdichten unzureichend. Eine erhebliche Verbesserung wurde mit sogenannter DCB-Keramik, einer in einem speziellen Bondverfahren ein- oder beidseitig mit Kupfer in Platinenform beschichteten Keramik, erzielt. Aber auch Aufbauten mit dieser Keramik zeigen bei großflächigen Baueinheiten Verformungen und Beschädigungen der Keramik. Daher bestand ein dringendes Bedürfnis nach großflächigen Keramikbauteilen für Halbleiter-Hochleistungsanordnungen mit potentialfreiem Aufbau.

Nun ist vorgeschlagen worden, zur Vermeidung der genannten Schwierigkeiten bei potentialfreiem Aufbau von Halbleiter-Baueinheiten hoher Leistung mit einer oder mehreren Halbleitertabletten auf einem Trägerkörper die isolierende Zwischenscheibe aus wenigstens zwei gegenseitig beabstandeten Stücken auszubilden, welche über leitende überbrückungen galvanisch verbunden sind. Einem solchen Aufbau haften jedoch auch Nachteile an. Die Endmaße und Detailabstände von Strukturbereichen der oberen Kupferbeschichtung zu einer Bezugskante liegen in unzulässigen Toleranzbereichen. Infolge der dichten Packung von Funktionsbereichen je Halbleitertablette und ihrer teilweise sehr kleinen Abmessungen - die Abmessungen der Kontaktstellen der Funktionsbereiche sind noch erheblich geringer - ist bei überschreiten von Flächenmaßtoleranzen die flächengenaue Kontaktierung mittels Bonden auf den Halbleitertabletten nicht mehr gewährleistet.

Weiter ist als Bezugskante der Trägerplatte jeweils eine Kante der Keramikplättchen vorgesehen. Bei überstehen der oberen Kupfer-Beschichtung über das jeweilige Keramikplättchen entsteht eine weitere Bezugskante, die eine unzulässige, maßüberschreitende Kontaktauflage beim Aufsetzen von Kontaktstücken eines Gehäuseoberteils zur Folge hat. Dabei können z.B. Toleranzen von ca. 0,3mm je Seite um 0,5mm und mehr überschritten werden. Auch durch gegenseitig versetzte Position der Keramikplättchen entstehen unzulässige Lageänderungen im Verlauf der Struktur der oberen Metallbeschichtung, die wie die vorgenannten Nachteile nicht auszugleichen sind und daher zum Ausfall der Trägerplatte führen. Die Ursache für diese Veränderungen besteht in der unterschiedlichen Längenausdehnung der zu verbindenden Materialien Keramik und Kupfer sowie darin, daß die zu verbindenden Teile bei den hohen Temperaturen des Fertigungsverfahrens nicht fest angeordnet sein können.

Der Erfindung liegt die Aufgabe zugrunde, eine elektrisch isolierende und thermisch leitende Trägerplatte für Halbleiter-Baueinheiten anzugeben, bei welcher die genannten Nachteile des bekannten Standes der Technik vermieden sind: Sie soll unabhängig von fertigungsbedingten Toleranzen der Flächenmaße sowie von Toleranzen der Platinenstruktur der Schaltungsseite fest vorgegebene Justiermaße für rationelle Weiterbehandlung, insbesondere für maßgenaue räumliche Anordnung von darauf zu befestigenden und mit Stromleiterteilen zu versehenden Halbleiterstrukturen gewährleisten.

Die Lösung der Aufgabe besteht bei einer Trägerplatte der eingangs erwähnten Art in den kennzeichnenden Merkmalen des Anspruchs 1. Vorteilhafte Weiterbildungen sind in den Unteransprüchen angegeben.

Anhand der in den Figuren dargestellten Ausführungsbeispiele wird die Erfindung erläutert. Figur 1 zeigt in Seitenansicht den Schichtenaufbau einer Trägerplatte, Figur 2 in Draufsicht eine Trägerplatte mit versetzt angeordneten Bauteilen. In Figur 3 ist, ebenfalls in Draufsicht, eine Trägerplatte mit uber die versetzt angeordneten Bauteile überstehender, oberseitiger Metallisierung dargestellt, und Figur 4 zeigt, auch in Draufsicht, eine Trägerplatte nach der Erfindung. Für gleiche Teile sind in allen Figuren gleiche Bezeichnungen gewählt.

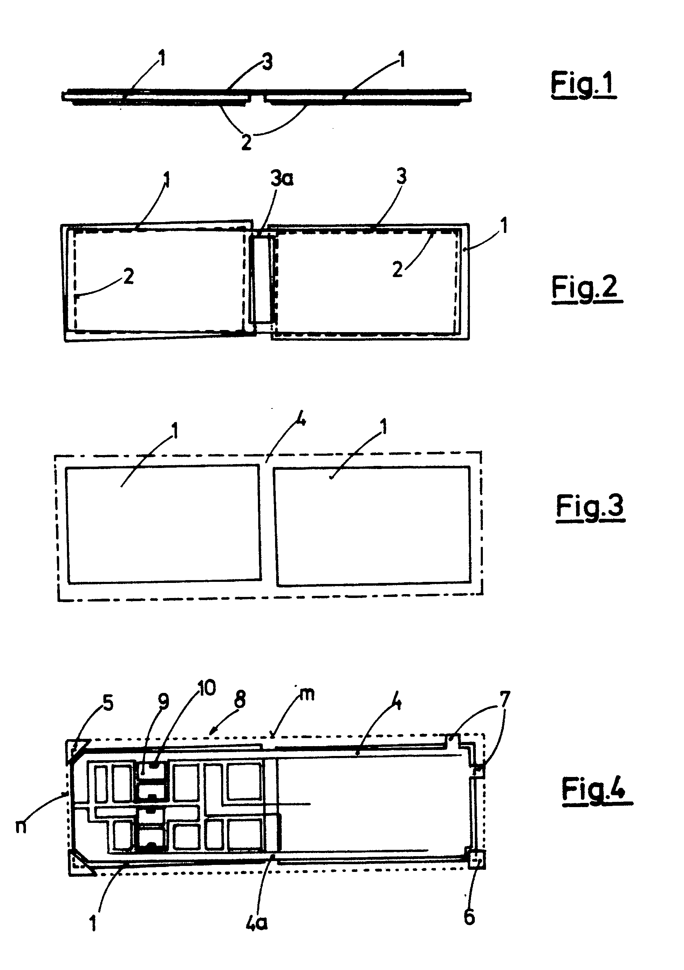

Eine Trägerplatte gemäß Figur 1 besteht aus wenigstens zwei in gleicher Ebene in gegenseitigem Abstand angeordneten Keramikplättchen (1) aus thermisch gut leitender Keramik. An ihrer Unterseite sind die Plättchen (1) jeweils mit einer Metallisierung (2) aus Kupfer beschichtet. An der Oberseite ist eine durchgehende, beide Plättchen (1) verbindende Metallisierung (3) ebenfalls aus Kupfer befestigt. Beide Metallisierungen (2,3) sind durch ein Hochtemperatur-Bondverfahren direkt mit der Keramik fest verbunden. Ein solcher Aufbau ist als sogenannte DCB-Keramik bekannt. Die Unterteilung der Keramik ermöglicht großflächige Trägerplatten für Anwendungen der Halbleiter-Hochleistungselektronik mit thermischer Wechselbelastung.

Der Nachteil der unerwünschten, verfahrensbedingt gegenseitig versetzten Zuordnung insbesondere der Keramikplättchen (1) und der oberseitigen Metallisierung (3) ist aus der Darstellung in Figur 2 zu erkennen. Die Metallisierungen (3) sind über stegförmige Fortsätze (3a) galvanisch verbunden. Zur Verdeutlichung sind die Keramikplättchen (1) in extremer Versetzung gezeichnet. Eine solche Lageveränderung bedeutet bei Strukturierung der oberen Metallisierung für dichte Packung von Halbleitertabletten mit sehr engen Toleranzen für die Kontaktierung den Ausfall der Trägerplatte. Aus der Darstellung ist weiter erkennbar, daß ein derartiger Aufbau auch zur rationellen Weiterverarbeitung ungeeignet ist, da er wegen fehlender Bezugskante bei nachfolgenden Verfahrensschritten keine Justierung ermöglicht. Außerdem ist häufig die insbesondere beim Einsatz in der Leistungselektronik gestellte Forderung nach hoher Spannungsüberschlagsfestigkeit zwischen spannungsführenden Bauelementen beiderseits der Keramikplättchen (1) nicht erfüllt, weil die oberseitig strukturierte Metallisierung in vielen Fällen über den Rand der Keramikplättchen übersteht oder zumindest bündig mit ihnen abschließt und damit der erforderliche Isolationsabstand nicht gegeben ist.

Dieser bekannte Aufbau wird gemäß der Erfindung in überraschend einfacher Weise dadurch verbessert, daß als oberseitige Metallisierung eine am ganzen Umfang der aufgereihten Keramikplättchen überstehende Metallplatte vorgesehen ist, aus welcher eine in der Flächenausdehnung den Plättchen (1) angepaßte Metallisierung gebildet ist, die im Verlauf der Umfangslinie der Plättchen über dieselben vorstehende, als Justierenden dienende Fortsätze aufweist. Damit ist ein sowohl toleranzunabhängiger als auch an jeder Seite justierbarer und außerdem überschlagfester Aufbau gegeben.

Figur 3 soll lediglich zeigen, daß auf den unregelmäßig liegenden Keramikplättchen (1) eine am gesamten äußeren Umfang der Plättchen überstehende Metallisierung vorgesehen ist.

Figur 4 zeigt den Aufbau gemäß der Erfindung mit einer in ihrer Flächenausdehnung gegenüber den Keramikplättchen (1) verringerten, oberen Metallisierung (4), deren ursprüngliche Umfangslinie mit m, n bezeichnet sind, wobei nunmehr die unterbrochenen Linien m, n die Bezugslinien zur Justierung des Aufbaus bei der Weiterverarbeitung darstellen. Mit (5) bis (7) sind nach Verringerung der Metallisierungsfläche verbliebene, erfindungsgemäße Justierenden bezeichnet. Sie können beliebige Flächenform aufweisen und entweder nur einen Justierpunkt oder aber eine Justierkante bilden. Gemäß der Darstellung sind sie dreieckförmig (5) oder viereckförmig (6) ausgebildet und jeweils auf der Keramik mit einem Isolationsabstand gegenüber Abschnitten der Struktur (8) der Metallisierung (4) befestigt. Die Außenkanten der Justierenden (5, 6, 7) bestimmen in der Fluchtung zwischen benachbarten Fortsätzen die Anlegelinien m, n für den Aufb au und bilden jeweils die entsprechende Bezugskante.

Die Metallisierung (4) ist so ausgestaltet, daß sowohl längs der Außenkanten als auch längs der beiden gegenüberliegenden Innenkanten der Keramikplättchen (1) ein vorgegebener Abstand zur Keramikkante besteht.

Die Justierenden können auch stegförmig ausgebildet und im Verlauf der Lang- und Schmalseiten der Trägerplatte angebracht und, falls der angrenzende Abschnitt der Struktur (8) kein Potential oder aber Erdpotential aufweist, mit diesem verbunden sein. Mit (4a) sind Verbindungsstege der oberen Metallisierung (4) zur überbrückung des Abstandes zwischen den Keramikplättchen (1) bezeichnet. Die Struktur (8) der Metallisierung ist lediglich mit wenigen Abschnitten angedeutet, und eine Halbleitertablette (9) weist eine Kontaktstelle (10) auf. Damit wird auch gezeigt, daß Lageveränderungen der Trägerplattenteile, insbesondere der oberen Metallisierungen, bei kleinen Kontaktflächen und damit geringsten Toleranzen zu Fehlstellen in der Struktur führen können. Diese Gefahr besteht ebenso, wenn Gehäuseoberteile so auf die Trägerplatte aufgebracht werden, daß vom Gehäuseoberteil auf Kontaktstellen der Struktur aufsitzende Stormleiterenden mit letzteren verbunden werden sollen.

Die Erfindung ist gleich vorteilhaft bei Einzelkeramik anwendbar.

Ferner können die Justierenden auch mittels einer an der Keramikunterseite angebracht Metallplatte ausgebildet sein. Die Keramikoberseite weist dann eine ausschließlich innerhalb der Umfangslinien der Keramik sich erstreckende, strukturierte Metallisierung auf.

Die Vorteile der Erfindung bestehen darin, daß die Ausgestaltung der oberen Metallisierung für jede gewünschte Schaltkonfiguration leicht erzielbar ist, daß alle Maßanforderungen erfüllbar sind, daß jede beliebige Justierung zur Weiterverarbeitung der Trägerplatte ermöglicht wird, und daß Aufbauten mit jeder gewünschten Unterteilung der Keramik berücksichtigt werden können. Demzufolge unterliegt die Anwendung der Erfindung keinen Einschränkungen.

**Ansprüche**

1. Trägerplatte für Halbleiter-Baueinheiten,
   - bestehend aus wenigstens einer Keramikplatte und
   - je einer an jeder der beiden Flächen der Keramikplatte befestigten Metallisierung,
   **dadurch gekennzeichnet,daß**

   - aus einer für wenigstens eine Metallisierung vorgesehenen, durchgehenden, an allen Seiten über die Keramik vorstehenden Metallplatte eine der Keramik angepaßte Metallisierung kleinerer Flächenausdehnung gebildet ist,
   - die aus der Metallplatte gebildete Metallisierung im Verlauf der ganzen Umfangslinie der Keramik über diese vorstehende Fortsätze aufweist, und
   - die Fortsätze als Justierenden vorgesehen sind, deren Verbindungslinie längs der Keramik-Umfangslinien als Bezugslinien zur Weiterverarbeitung dienen.

2. Trägerplatte nach Anspruch 1, dadurch gekennzeichnet, daß die Justierenden auf der mit einer strukturierten Metallisierung für vorgesehene Schaltungsbauteile versehenen Keramikfläche befestigt sind.

3. Trägerplatte nach Anspruch 1 oder 2, dadurch gekennzeichnet, daß die Justierenden jeweils an einer Ecke der Keramik so angebracht sind, daß sie zu jeder von im Winkel angeordneten Bezugslinienbeitragen.

4. Trägerplatte nach Anspruch 1, dadurch gekennzeichent, daß die Justierenden bogenförmig ausgebildet sind.

5. Trägerplatte nach Anspruch 1, dadurch gekennzeichent, daß die Justierenden vieleckförmig ausgebildet sind.

6. Trägerplatte nach Anspruch 1, dadurch gekennzeichnet, daß die Justierenden jeweils im Verlauf zwischen den Ecken der Keramik angebracht sind.

7. Trägerplatte nach Anspruch 1, dadurch gekennzeichnet, daß die Keramik aus zwei oder mehr in einer Ebene in gegenseitigem Abstand angeordneten Stücken besteht und die strukturierte Metallisierung der Keramikstücke jeweils durch überlappende Ausbildungen verbunden sind.

Fig.1

Fig.2

Fig.3

Fig.4